# EUROPEAN PATENT APPLICATION

(11) **EP 4 637 039 A1**
(43) Date of publication of application: **22.10.2025**
(21) Application number: 24744832.7
(22) Date of filing: 15.01.2024
(51) Int. Cl.: H04B 1/12, H04B 1/10, H04B 17/24, H03F 1/32, G06N 3/04

(54) **METHOD, SYSTEM, AND DEVICE FOR REDUCING TRAINING OVERHEAD DURING AI-BASED NONLINEARITY CORRECTION**

(30) Priority: 16.01.2023 KR 20230006177
(71) Applicant: Samsung Electronics Co., Ltd., Suwon-si, Gyeonggi-do 16677 (KR)
(72) Inventor: PARK, Seungil, Suwon-si, Gyeonggi-do 16677 (KR); KIM, Suhwook, Suwon-si, Gyeonggi-do 16677 (KR); SEO, Bongsung, Suwon-si, Gyeonggi-do 16677 (KR); JANG, Hyeondeok, Suwon-si, Gyeonggi-do 16677 (KR); HWANG, Byeonghun, Suwon-si, Gyeonggi-do 16677 (KR)
(74) Representative: Nederlandsch Octrooibureau
(86) International application number: PCT/KR2024/000717
(87) International publication number: WO 2024/155052

(57) **Abstract**

The present disclosure relates to a 6G communication system for achieving high data transmission rates and ultra-low latency compared to 4G and 5G communication systems. A method performed by a receiver in a wireless communication system according to an embodiment disclosed herein may comprise the steps of: receiving first uplink data from a transmitter via a first resource; acquiring a first parameter for the nonlinearity compensation of a power amplifier (PA) with respect to the first resource through artificial intelligence (AI) training; performing distortion correction of the nonlinearity of the first uplink data on the basis of the first parameter; receiving second uplink data from the transmitter via a second resource; and checking whether the nonlinearity of the PA changed between the first uplink data transmission and the second uplink data transmission.

## Description

### [Technical Field]

The disclosure relates to a method, a system, and a device for reducing training overhead when performing, by a reception device, artificial intelligence (AI)-based correction of signal distortion occurring due to nonlinearity of a power amplifier (PA) when a transmission device performs AI-based data transmission.

### [Background Art]

A review of the development of wireless communication from generation to generation shows that the development has mostly been directed to technologies for services targeting humans, such as voice-based services, multimedia services, and data services. It is expected that connected devices which are exponentially increasing after commercialization of 5th generation (5G) communication systems will be connected to communication networks. Examples of things connected to networks may include vehicles, robots, drones, home appliances, displays, smart sensors installed in various infrastructures, construction machines, factory equipment, and the like. Mobile devices are expected to evolve into various form factors, such as augmented reality glasses, virtual reality headsets, and hologram devices. In order to provide various services by connecting hundreds of billions of devices and things in the 6th-generation (6G) era, there have been ongoing efforts to develop improved 6G communication systems. For these reasons, 6G communication systems are referred to as "beyond-5G" systems.

6G communication systems, which are expected to be implemented approximately by 2030, will have a maximum transmission rate of tera (1,000 giga)-level bps and a radio latency of 100 µ sec. That is, 6G communication systems will be 50 times as fast as 5G communication systems and have the 1/10 radio latency thereof.

In order to accomplish such a high data transmission rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, a technology capable of securing the signal transmission distance (that is, coverage) will become more crucial. It is necessary to develop, as major technologies for securing the coverage, multiantenna transmission technologies including radio frequency (RF) elements, antennas, novel waveforms having a better coverage than OFDM, beamforming and massive MIMO, full dimensional MIMO (FD-MIMO), array antennas, and large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the frequency efficiencies and system networks, the following technologies have been developed for 6G communication systems: a full-duplex technology for enabling an uplink (UE transmission) and a downlink (node B transmission) to simultaneously use the same frequency resource at the same time; a network technology for utilizing satellites, high-altitude platform stations (HAPS), and the like in an integrated manner; a network structure innovation technology for supporting mobile nodes B and the like and enabling network operation optimization and automation and the like; a dynamic spectrum sharing technology though collision avoidance based on spectrum use prediction, an artificial intelligence (AI)-based communication technology for implementing system optimization by using AI from the technology design step and internalizing end-to-end AI support functions; and a next-generation distributed computing technology for implementing a service having a complexity that exceeds the limit of UE computing ability by using super-high-performance communication and computing resources (mobile edge computing (MEC), clouds, and the like). In addition, attempts have been continuously made to further enhance connectivity between devices, further optimize networks, promote software implementation of network entities, and increase the openness of wireless communication through design of new protocols to be used in 6G communication systems, development of mechanisms for implementation of hardware-based security environments and secure use of data, and development of technologies for privacy maintenance methods.

It is expected that such research and development of 6G communication systems will enable the next hyper-connected experience in new dimensions through the hyper-connectivity of 6G communication systems that covers both connections between things and connections between humans and things. Specifically, it is expected that services such as truly immersive XR, high-fidelity mobile holograms, and digital replicas could be provided through 6G communication systems. In addition, with enhanced security and reliability, services such as remote surgery, industrial automation, and emergency response will be provided through 6G communication systems, and thus these services will be applied to various fields including industrial, medical, automobile, and home appliance fields.

### [Disclosure of Invention]

### [Technical Problem]

As described above, various services can be provided according to the development of a mobile communication system, and thus, a method for improving data reception performance and increasing coverage through compensation of the nonlinearity of a PA is required.

The disclosure proposes a method for preventing performance deterioration according to nonlinearity compensation of a PA.

### [Solution to Problem]

A method performed by a receiver in a wireless communication system according to an embodiment of the disclosure may include receiving first uplink data from a transmitter via a first resource, acquiring a first parameter for compensation of the nonlinearity of a power amplifier (PA) for the first resource through artificial intelligence (AI) training, performing, based on the first parameter, distortion correction of the nonlinearity of the first uplink data, receiving second uplink data from the transmitter via a second resource, and identifying whether the nonlinearity of the PA is changed between transmission of the first uplink data and transmission of the second uplink data.

A receiver in a wireless communication system according to another embodiment of the disclosure may include a transceiver and a controller, wherein the controller is configured to receive first uplink data from a transmitter via a first resource, and acquire a first parameter for compensation of the nonlinearity of a power amplifier (PA) for the first resource through artificial intelligence (AI) training.

The controller is configured to perform, based on the first parameter, distortion correction of the nonlinearity of the first uplink data, receive second uplink data from the transmitter via a second resource, and identify whether the nonlinearity of the PA is changed between transmission of the first uplink data and transmission of the second uplink data.

### [Advantageous Effects of Invention]

According to an embodiment of the disclosure, when factors affecting nonlinearity are not largely changed, an AI training process is omitted and a parameter of an AI network, which previously trained, can be reused.

Nonlinearity is affected by various causes, and thus a new AI training process needs to be performed for each data transmission by using a pilot signal. When factors affecting the nonlinearity are not largely changed, an AI training process can be omitted, and a parameter of an AI network, which is previously trained, can be reused, whereby performance deterioration due to AI training can be prevented.

### [Brief Description of Drawings]

Accompanying drawings included as part of detailed description for understanding the disclosure provide embodiments of the disclosure and describe technical features of the disclosure with detailed description.
FIG. 1 illustrates signal distortion due to nonlinearity of an amplifier according to an embodiment.
FIG. 2 illustrates an embodiment of a reception path of a receiver according to the disclosure.
FIG. 3 illustrates an effect of enhancing data reception performance when NC technology is applied according to an embodiment of the disclosure.
FIG. 4A illustrates an embodiment of a method of training a parameter of an AI network in first transmission and performing only inference without training in second transmission in cases of an uplink (UL) and a downlink (DL), respectively.
FIG. 4B illustrates an embodiment of a method of training a parameter of an AI network in first transmission and performing only inference without training in second transmission in cases of an uplink (UL) and a downlink (DL), respectively.
FIG. 5 illustrates an embodiment of a method of performing pre-trained inference in a UL case according to the disclosure.
FIG. 6 illustrates an embodiment of a pre-trained inference method of a transmitting end in transmission according to the disclosure.
FIG. 7 illustrates an embodiment of a pre-trained inference method of a receiving end in transmission according to the disclosure.
FIG. 8 illustrates an embodiment of a method of performing pre-trained inference in a UL case according to the disclosure.
FIG. 9 illustrates an embodiment of a method of performing pre-trained inference in a UL case according to the disclosure.
FIG. 10A illustrates an embodiment of a method of performing pre-trained inference in a UL case according to the disclosure.
FIG. 10B illustrates an embodiment of a method of performing pre-trained inference in a UL case according to the disclosure.
FIG. 11A illustrates an embodiment of a method of performing pre-trained inference in a UL case according to the disclosure.
FIG. 11B illustrates an embodiment of a method of performing pre-trained inference in a UL case according to the disclosure.
FIG. 12 is a block diagram of a UE according to an embodiment of the disclosure.
FIG. 13 is a block diagram of a base station according to an embodiment of the disclosure.

### [Mode for the Invention]

To meet the demand for wireless data traffic having increased since deployment of 4th generation (4G) communication systems, efforts have been made to develop an improved 5th generation (5G) or pre-5G communication system. Therefore, the 5G or pre-5G communication system is also called a "beyond 4G network" communication system or a "post long term evolution (post LTE)" system.

The 5G communication system is considered to be implemented in ultrahigh frequency (mmWave) bands, (e.g., 60GHz bands) so as to accomplish higher data rates. To decrease propagation loss of the radio waves and increase the transmission distance of radio waves in the ultrahigh frequency bands, beamforming, massive multiple-input multiple-output (massive MIMO), full dimensional MIMO (FD-MIMO), array antenna, analog beam forming, large scale antenna techniques are under discuss ion in the 5G communication systems. In addition, in the 5G communication system, technical development for system network improvement is under way based on evolved small cells, advanced small cells, cloud radio access networks (cloud RANs), ultra-dense networks, device-to-device (D2D) communication, wireless backhaul, moving network, cooperative communication, coordinated multi-points (CoMPs), reception-end interference cancellation, and the like. In the 5G system, hybrid FSK and QAM modulation (FQAM) and sliding window superposition coding (SWSC) as an advanced coding modulation (ACM) scheme, and filter bank multi carrier (FBMC), non-orthogonal multiple access (NOMA), and sparse code multiple access (SCMA) as an advanced access technology have also been developed.

Since a 5G communication system must freely reflect various requirements of users, service providers, and the like, services satisfying various requirements must be supported. The services considered in the 5G communication system include enhanced mobile broadband (eMBB) communication, massive machine-type communication (mMTC), ultra-reliability low-latency communication (URLLC), and the like.

eMBB aims at providing a data rate higher than that supported by existing LTE, LTE-A, or LTE-Pro. For example, in the 5G communication system, eMBB must provide a peak data rate of 20 Gbps in the downlink and a peak data rate of 10 Gbps in the uplink for a single base station. Furthermore, the 5G communication system must provide an increased user-perceived data rate to the UE, as well as the maximum data rate. In order to satisfy such requirements, transmission/reception technologies including a further enhanced multi-input multi-output (MIMO) transmission technique are required to be improved. In addition, the data rate required for the 5G communication system may be obtained using a frequency bandwidth more than 20 MHz in a frequency band of 3 to 6 GHz or 6 GHz or more, instead of transmitting signals using a transmission bandwidth up to 20 MHz in a band of 2 GHz used in LTE.

In addition, mMTC is being considered to support application services such as the Internet of Things (IoT) in the 5G communication system. mMTC has requirements, such as support of connection of a large number of UEs in a cell, enhancement coverage of UEs, improved battery time, a reduction in the cost of a UE, and the like, in order to effectively provide the Internet of Things. Since the Internet of Things provides communication functions while being provided to various sensors and various devices, it must support a large number of UEs (e.g., 1,000,000 UEs/km²) in a cell. In addition, the UEs supporting mMTC may requires wider coverage than those of other services provided by the 5G communication system because the UEs are likely to be located in a shadow area, such as a basement of a building, which is not covered by the cell due to the nature of the service. The UE supporting mMTC must be configured to be inexpensive, and requires a very long battery life-time such as 10 to 15 years because it is difficult to frequently replace the battery of the UE.

Lastly, URLLC is a cellular-based mission-critical wireless communication service. For example, a service supporting URLLC must satisfy an air interface latency of less than 0.5 ms, and may also require a packet error rate of 10-5 or less. Thus, URLLC must provide communication with ultra-low latency and ultra-high reliability. For example, a service supporting URLLC must satisfy an air interface latency of less than 0.5 ms, and also requires a packet error rate of 10⁻⁵ or less. For example, a service supporting URLLC must satisfy an air interface latency of less than 0.5 ms, and may also require a packet error rate of 10-5 or less.

In order to satisfy these various services, a wide bandwidth is required. Accordingly, research on a high bandwidth that has not been used before is being conducted, and mmWave and THz research are being conducted in 5G and beyond-6G communication systems. However, in the ultra-high frequency band, the propagation path loss of radio waves is serious, resulting in narrow coverage. Due to this issue, in the case of base stations having narrow coverage, too many base stations are required to be installed, resulting in large capital expenditures (CAPEX).

Various technologies have been provided to solve the coverage issue. Among these technologies, a method for performing transmission at a higher-output power using a power amplifier (PA) is provided. However, since non-linearity in which the phase and amplitude of a transmission signal are distorted occurs in the high-output power region of the PA, the use of PA with high-output power is limited. Accordingly, a back-off process of limiting the operating range of the PA to an output power lower than the maximum output power of the PA is performed to prevent operation in a nonlinear region. When the back-off process is applied, a probability in which an input signal of the PA is included in the nonlinear region is lowered, so as to prevent data reception performance deterioration due to the nonlinearity, but the transmission power is relatively lowered, resulting in coverage loss. In order to solve this problem, peak-to-average power ratio (PAPR) reduction technology, digital pre-distortion (DPD) technology, and non-linearity compensation (NC) technology are being considered, and research on a method for solving the nonlinearity using artificial intelligence (AI) is also being conducted.

AI may be divided into supervised learning in which a ground-truth value is basically given, and a model is trained by learning the ground-truth value as the labeling value of training data, unsupervised learning that extracts relationships and characteristics between data without a ground truth value, and reinforcement learning in which AI is trained through a compensation system. Although the supervised learning among them may have a difficulty in collecting labeled data, the supervised learning may train AI having good performance. In AI, there are an offline-training method for loading a well-trained model from the beginning, and an online-training method for continuously updating a model to reflect the ever-changing environment. In the offline-training case, when a model does not need to be changed, additional training is not necessary after training the model once with a large dataset. That is, the model may be pre-trained during a chip design process, and the trained AI model can be loaded into a chip algorithm. However, in a case where the environment continuously changes, a fixed model has a difficulty reflecting the changing environment, and thus online-training in which the model is continuously updated is necessary.

The Internet, which is a human centered connectivity network where humans generate and consume information, is now evolving to the Internet of things (IoT) where distributed entities, such as things, exchange and process information without human intervention. The Internet of everything (IoE), which is a combination of the IoT technology and the big data processing technology through a connection with a cloud server, etc. has emerged. As technology elements, such as "sensing technology", "wired/wireless communication and network infrastructure", "service interface technology", and "security technology" have been demanded for IoT implementation, a sensor network, a machine-to-machine (M2M) communication, machine type communication (MTC), and so forth have recently been researched. Such an IoT environment may provide intelligent Internet technology (IT) services that create a new value to human life by collecting and analyzing data generated among connected things. IoT may be applied to a variety of fields including smart home, smart building, smart city, smart car or connected cars, smart grid, health care, smart appliances and advanced medical services through convergence and combination between existing information technology (IT) and various industrial applications.

As described above, various services may be provided according to the development of a mobile communication system, and thus, a method for improving data reception performance and increasing coverage through compensation of the nonlinearity of a PA is required.

In order to achieve time and frequency synchronization and exchange information on the channel, various pilots or reference signals (RSs) have been used. For example, there are a primary synchronization signal (PSS) and a secondary synchronization signal (SSS) used for initial access, a demodulation RS (DMRS) used to estimate a channel value required when demodulating transmission data, a channel state information-RS (CSI-RS) used to estimate the state of a downlink (DL) channel in a terminal, a sounding RS (SRS) used to estimate the state of an uplink (UL) channel in a base station, and the like. An appropriate value for transmission power of the pilot may be determined in consideration of reception power targeted at the receiving end and a communication system and environment.

In order to estimate channel information to be utilized for various purposes such as scheduling, beam management, and equalizer, a pattern of pilots commonly given to the transmitting and receiving ends is compared with a pattern of received pilots. This characteristic is useful for labeling when supervised learning is performed, and thus an accurate channel state can be identified and data reception performance can be increased.

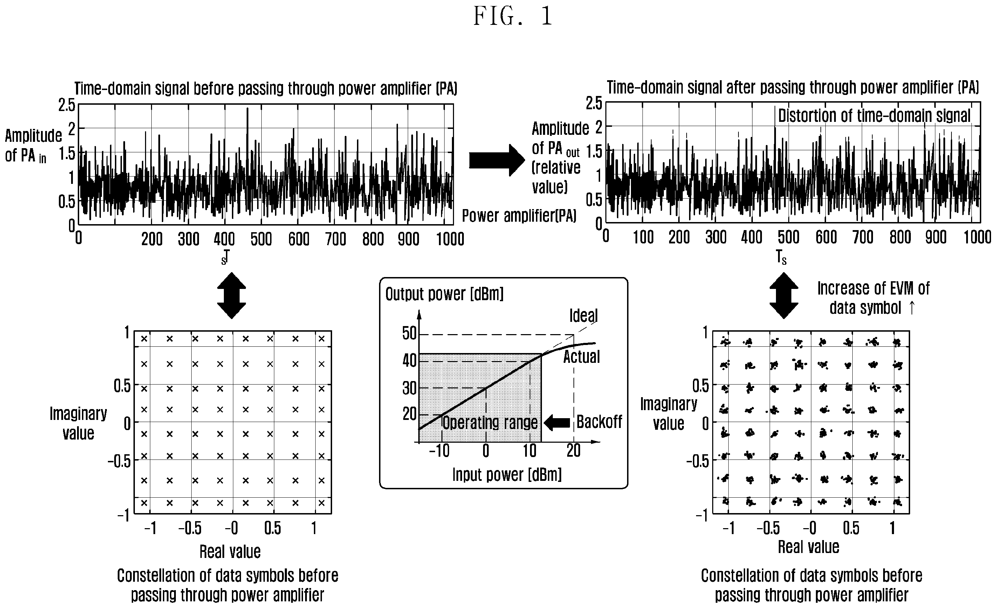

Meanwhile, when a power amplifier (PA) for amplifying output power of a signal for the purpose of increasing coverage, a problem that an error vector magnitude (EVM) of a transmission data symbol is increased and data reception performance deteriorates due to nonlinearity which causes distortion of the phase and strength of the signal in the high-output power region occurs as shown in FIG. 1. A method of restricting an operating range of the PA to a linear interval by applying back-off in order to reduce such an influence may reduce the EVM of the transmission symbol, but transmission output power is reduced, which thus causes coverage loss.

As described above, a power amplifier (PA) of amplifying output power of a signal can be used at a transmitting end for the purpose of increasing coverage, etc.

FIG. 1 illustrates signal distortion due to nonlinearity of an amplifier according to an embodiment.

Referring to FIG. 1, when a PA is used, a problem that an error vector magnitude (EVM) of a transmission data symbol is increased due to nonlinearity causing distortion of the phase and strength of a signal in a high-output power region and data reception performance deteriorates may occur. A method of restricting an operating range of the PA to a linear interval by applying back-off in order to reduce such an influence may reduce the EVM of the transmission symbol, but transmission output power is reduced, which may thus cause coverage loss.

In this case, a method of compensating nonlinearity by utilizing AI at a receiving end while utilizing the same high-output power region of the PA has been considered one of the conventional methods. In the disclosure, the method of compensating nonlinearity of the PA is referred to as a nonlinearity compensation (NC) technology or an NC method. However, the technical scope of the disclosure is not limited by the use of the term.

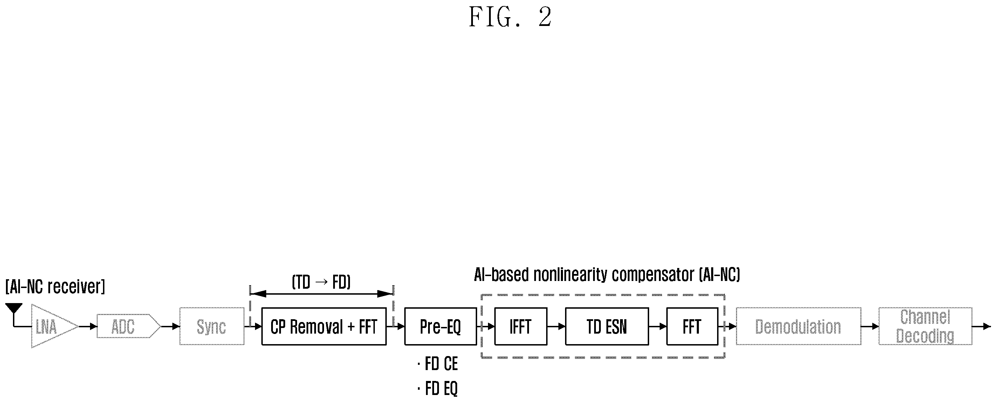

FIG. 2 illustrates an embodiment of a reception path of a receiver according to the disclosure.

Referring to FIG. 2, an OFDM demodulation scheme may be applied to a receiver. A reception path may include a low noise amplifier (LNA), an analog-to-digital converter (ADC), a sync block, a CP removal block, a nonlinearity compensation (NC) block, a fast Fourier transform (FFT) block, a demodulation block, and a channel decoding block.

The ADC block may covert an analog signal into a digital signal. The CP removal block may generate a serial time-domain baseband signal. The serial time-domain baseband signal may be converted into a parallel time-domain baseband signal. The NC block may compensate nonlinearity of the PA by applying the above-proposed methods to a signal from which the CP has been removed. That is, the magnitude of power distorted by the nonlinearity of the PA may be compensated for. The signal to which the NC is applied may be converted into a frequency-domain signal through the FFT block, the modulated symbol may be demodulated and decoded through the demodulation block and the channel decoding block, and an original input data stream can thus be restored.

For example, an operation of compensating, based on an amplitude scaling factor, the nonlinearity of the PA at the receiving end according to the method and/or the embodiment proposed in the disclosure may be performed in the NC block of the reception path. Specifically, the above-described procedures of acquiring input/output relation information and compensating power for a data signal may be performed in the NC block. In addition, amplitude recovery for the amplitude scaling factor may be performed after the application of NC, and thereafter, the signal reflecting the amplitude recovery may be input to the FFT block. In a specific example, after power compensation in the NC block, a pilot signal may be divided by the amplitude scaling factor and transferred to the FFT block.

Each element of FIG. 2 may be implemented using hardware only or using hardware and software/firmware in combination. For example, while at least a part of the elements of FIG. 2 may be implemented as software, the other elements may be implemented using configurable hardware or using software and configurable hardware in combination. For example, the FFT block and the IFFT block may be implemented using a configurable software algorithm.

In addition, it is illustrated that the FFT and the IFFT are used, but it is merely provided as an example and the scope of the disclosure is not limited thereto. Accordingly, other types of transforms such as Discrete Fourier Transform (DFT) and Inverse Discrete Fourier Transform (IDFT) may be used.

The nonlinearity occurring at a transmitting end is affected by various causes such as output power (or the degree of back-off), the magnitude and position of a frequency resource used for transmission, and the type of a terminal, and thus a pilot signal transmitted in the same situation as the data signal part is required to compensate distortion in the data signal part, and the inference (distortion correction or inference) of the data signal can be made when a supervised learning-type AI training process is performed by utilizing the pilot signal. Hereinafter, the inference may means distortion correction (or inference) for the PA through AI.

The NC technology for compensating the nonlinearity of the PA may include a process of deriving and reporting an amplitude scaling factor based on the pilot part and the data part of the transmission signal from the perspective of the transmitting end, and may include a process of acquiring PA input/output relation information and a process of compensating the nonlinearity of the data transmission part of the reception signal based on the acquired information from the perspective of the receiving end. In this case, the PA input/output relationship information of the receiving end may be acquired by comparing a pattern of pilots already known by the transmitting end and the receiving end in common with the pilot transmission part of the signal actually received at the receiving end.

Here, the pilot may mean a pilot signal or a reference signal (RS), which is used, at the transmitting and receiving ends, to achieve time and frequency synchronization and exchange information on the channel. For example, the pilot or reference signal includes a primary synchronization signal (PSS) and a secondary synchronization signal (SSS) used for initial access, a demodulation RS (DMRS) used to estimate a channel value required when demodulating transmission data, a channel state information-RS (CSI-RS) used to estimate the state of a downlink (DL) channel in a terminal, a sounding RS (SRS) used to estimate the state of an uplink (UL) channel in a base station, and the like. The pilot signal or the reference signal may be commonly pre-defined or pre-configured for the transmitting end and the receiving end.

In the disclosure, for convenience of description, the term "pilot" is collectively used. However, the technical scope of the disclosure is not limited by the use of the term, and the term may be replaced by the terms such as "pilot signal" and "pilot symbol".

The acquired PA input/output relationship information may affect NC performance to be performed for the data transmission part of the reception signal of the receiving end. The more similar the distribution characteristics between the pilot transmission part of the transmission signal, which is used to acquire PA input/output relationship information, and the data transmission part of the transmission signal, which is used to perform NC based on the same, the more effectively the nonlinearity of the PA can be compensated. When the NC technology is performed at the receiving end, back-off applied to the PA can be reduced and output power can be increased, whereby coverage can be increased.

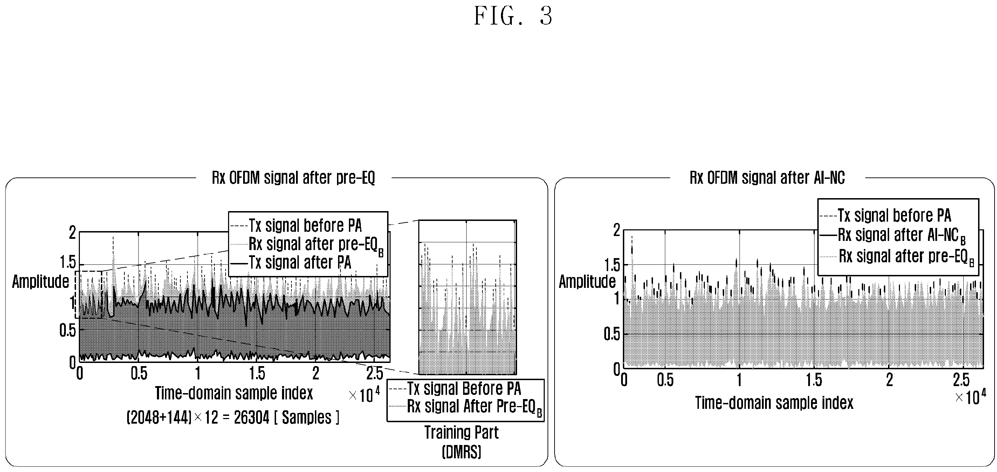

FIG. 3 illustrates an effect of enhancing data reception performance when NC technology is applied according to an embodiment of the disclosure. In the GPU vRAN-based implementation, it was identified that the proportion of training accounted for a significantly high percentage (70%) as a result of the delay analysis of AI-NC.

Hereinafter, a method for training a parameter of an AI network in first transmission and performing inference only without training in second transmission. A parameter trained in the previous transmission (i.e., first transmission) is called a pre-trained parameter.

The following results have been acquired according to the number of RBs and the positions of the RBs in the first transmission and the second transmission as a result of the pre-trained parameter-related USRP experiment.

- It was identified that, when the number of RBs and the positions of the RBs in the first transmission, the RBs being used for training a pre-trained parameter, were identical to the number of RBs and the positions of the RBs in the second transmission, the performance in a case where the pre-trained parameter is used for AI-NC distortion correction was identical to that of AI-NC distortion correction using real-time training.

- It was identified that, when the number of RBs in the second transmission is changed to the number of RBs in the first transmission, the performance of distortion correction using a pre-trained parameter is poorer compared to real-time training.

- It was identified that, when the number of RBs in the second transmission is identical to the number of RBs in the first transmission and the positions of the RBs in the second transmission is changed to the positions of the RBs in the first transmission, the performance of the AI-NC distortion correction gets poorer as a position change offset gets bigger.

The transmission power of the terminal is also considered. The power control is performed by the position of the terminal and a change in a channel situation, and output power of the terminal can be changed.

In general, the nonlinearity is affected by various causes as mentioned above, and thus an AI training process needs to be newly performed for each data transmission by utilizing a pilot signal. When factors affecting the nonlinearity have not been largely changed, the AI training process may be omitted and the previously trained parameter of the network can be utilized again.

The disclosure proposes a method for omitting an AI training process and utilizing a previously trained parameter of an AI network when factors affecting nonlinearity have not been largely changed.

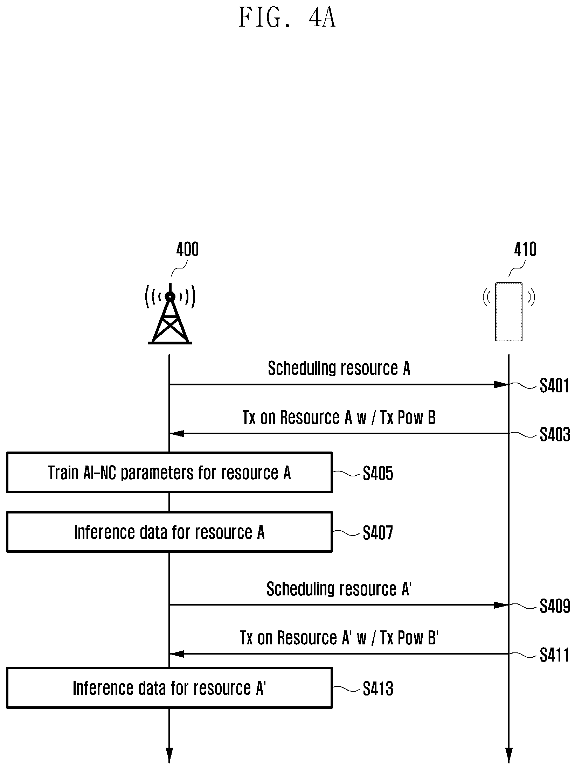

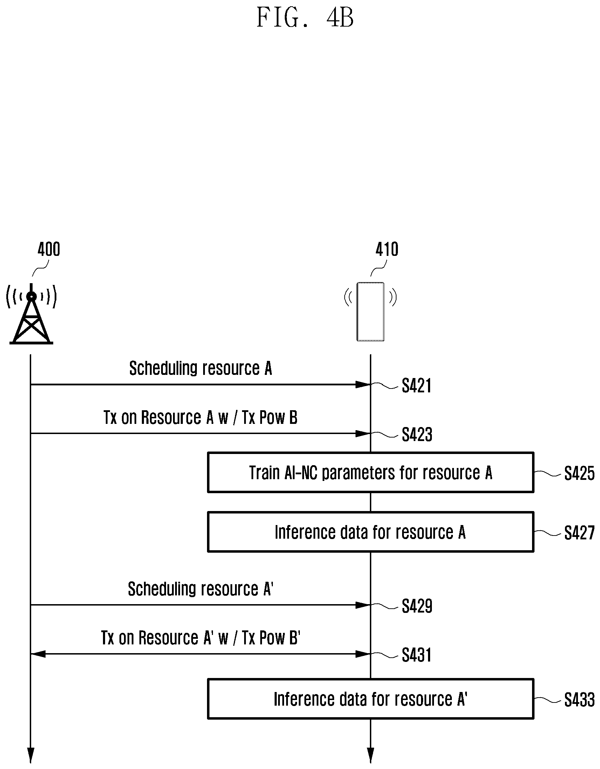

FIGS. 4A and 4B illustrate an embodiment of a method of training a parameter of an AI network in first transmission and performing only inference without training in second transmission in cases of an uplink (UL) and a downlink (DL), respectively.

FIG. 4 is an example of a UL case in which a terminal 410 transmits data and a base station 400 receives the data, and a DL case in which the base station 400 transmits data and the terminal 410 receives the data.

In the UL case, an entity for performing scheduling so that the terminal 410 transmits data is the base station 400. Accordingly, the base station 400 may continuously identify information such as the size and position of a frequency resource used for transmission among factors affecting nonlinearity. However, the output power of the terminal 410 is information that the base station 400 cannot identify. Accordingly, a procedure in which the base station 400 can identify that the corresponding factors (e.g., the output power of the terminal 410) have not been largely changed is required. When it is identified that the corresponding factors (e.g., the output power of the terminal 410) have not been largely changed, the base station 400 may omit the training process.

In operation S401, the base station 400 may schedule resource A for UL transmission for the terminal 410. Alternatively, the base station 400 may transmit scheduling information of resource A for UL transmission to the terminal 410.

In operation S403, the terminal 410 may perform UL transmission to the base station 400 through resource A at transmission power (Tx power) B.

In operation S405, the base station 400 may train AI-NC parameters for resource A. The base station 400 may train AI-NC parameters by using a pilot signal included in the signal transmitted in operation S403.

In operation S407, the base station 400 may perform inference for resource A.

In operation S409, the base station 400 may schedule resource A' for UL transmission for the terminal 410. Alternatively, the base station 400 may transmit scheduling information of resource A' for UL transmission to the terminal 410.

In operation S411, the terminal 410 may perform UL transmission to the base station 400 through resource A' at transmission power B'. In operation S413, the base station 400 may perform inference for resource A'.

In the DL case, the base station 400 not only can perform scheduling for data transmission and but also can identify information on output power, and thus the base station 400 may determine whether factors affecting the nonlinearity have been changed by the base station. However, in this case, data reception is performed by the terminal 410, and thus a procedure in which whether factors affecting the nonlinearity have been changed is informed to the terminal 410 is required so that the terminal 410 may determine whether to omit training.

In operation S421, the base station 400 may schedule resource A for DL transmission to the terminal 410. Alternatively, the base station 400 may transmit scheduling information of resource A for DL transmission to the terminal 410.

In operation S423, the base station 400 may perform DL transmission to the terminal 410 through resource A at transmission power (Tx power) B.

In operation S425, the terminal 410 may train AI-NC parameters for resource A.

In operation S427, the terminal 410 may perform inference for resource A.

In operation S429, the base station 400 may schedule resource A' for DL transmission to the terminal 410. Alternatively, the base station 400 may transmit scheduling information of resource A' for DL transmission to the terminal 410.

In operation S431, the base station 400 may perform DL transmission to the terminal 410 through resource A' at transmission power B'.

In operation S433, the terminal 410 may perform inference for resource A'.

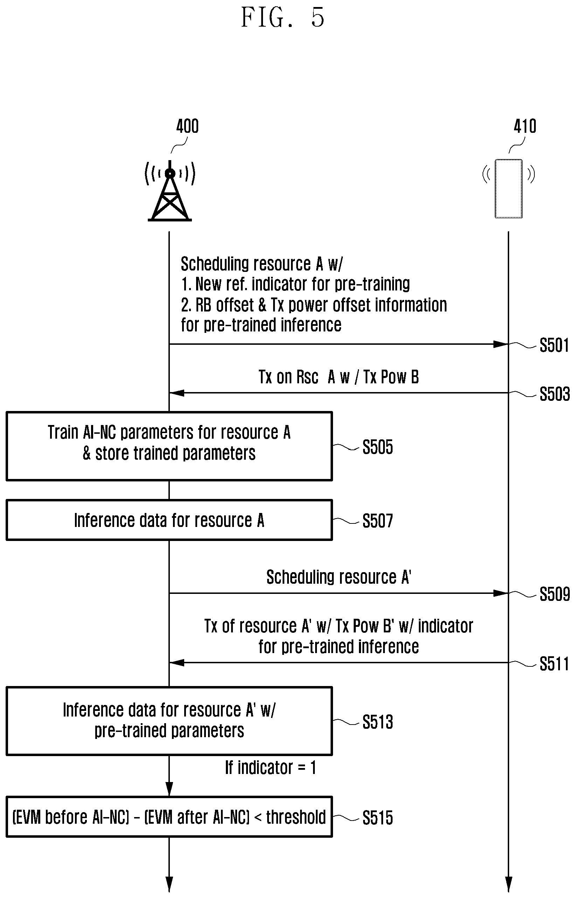

FIG. 5 specifically describes procedures required to omit a training process by a base station and a terminal with reference to a UL case. That is, FIG. 5 illustrates an embodiment of a method of performing pre-trained inference in a UL case according to the disclosure.

Referring to FIG. 5, in operation S501, the base station 400 may schedule resource A for UL transmission to the terminal 410. When scheduling specific UL transmission for the terminal 410, the base station 400 schedules a resource, which is resource A (Resource A or Rsc A), and may also transmit information on a new reference indicator indicating that a current transmission situation will be configured as a new reference point. In addition, the terminal 410 may inform the base station 400 of information enabling whether nonlinearity has been changed to be determined. That is, the inference is performed at a receiving end, and thus a transmission end may inform the receiving end of information enabling whether nonlinearity has been changed to be determined. In operation S503, the terminal 410 may perform UL transmission to the base station 400 through scheduled resource A at transmission power B.

For example, when the position of a currently scheduled resource is greatly changed by more than an RB offset, the base station 400 may determine, using provided information RB offset, that nonlinearity has been changed. Alternatively, the base station 400 may determine, using provided information Tx power offset, that nonlinearity has been changed when a difference between current output power Tx power B of the terminal 410 and output power Tx power B' to be used by the terminal 410 later is greater than the Tx power offset. Other factors which can affect nonlinearity, such as the size of the frequency resource, as well as the described embodiment may be used to define a criterion to determine whether the nonlinearity has been changed through sharing information in advance between the base station 400 and the terminal 410. In addition, various factors may be considered comprehensively to determine that the nonlinearity has been determined. For example, a change amount (X) of Tx power and a change amount (Y) of the frequency resource position may be considered comprehensively to determine that the nonlinearity has been changed when a value of (X+Y) is equal to or greater than Z. As advance information used to determine whether the nonlinearity has been changed, such as an RB offset or a Tx power offset, values agreed in advance between the terminal 410 and the base station 400 may be stored as a table and used. In this case, only an index value is exchanged for sharing the advance information, and thus a signaling cost can be reduced. In addition, the information required to determine the change of the nonlinearity, such as the RB offset or the Tx power, has a default value, and a default value commonly known to the terminal 410 and the base station 400 may be used even when no advance information is shared. The advance information used to determine the change of the nonlinearity, such as the RB offset or the Tx power offset, may be exchanged in advance in any prior operations in which the terminal 410 and the base station 400 communicate, rather than at a time point of setting a new reference point. For example, at a time point at which the terminal 410 accesses the base station 400, the base station 400 may share, in advance, the advance information used to determine the change of the nonlinearity to the terminal 410. The examples of a method for determining, by the base station 400, an accurate value of advance information used to determine the change of the nonlinearity, such as the RB offset or the Tx power offset, are as follows.
1) Values pre-stored in the base station 400 through a preliminary experiment, etc.
2) Make determination based on nonlinearity-related information provided by the terminal 410 when the information is terminal-specific information
3) Make adjustment adaptively to the performance of pre-trained inference

In operation S505, the base station 400 may train AI-NC parameters for resource A. The base station 400 may train AI-NC parameters by using a pilot signal included in the signal transmitted in operation S503. The new reference indicator is specified by the base station 400 in operation S501, and thus the terminal 410 may store the Tx power B value and the resource A value used thereafter. The base station 400 needs to store the AI-NC parameters after training the AI network since the AI-NC parameters can be reused later. Here, the AI-NC parameters may refer to parameters for distortion correction of the nonlinearity of the PA.

In operation S507, the base station 400 may perform distortion correction (or inference) of data for resource A.

In operation S509, the base station 400 may transmit information on scheduling for the second data transmission (i.e., transmission after configuration of the reference point) to the terminal 410. In operation S511, the terminal 410 may perform UL transmission to the base station 400 through resource A' at transmission power B'. In this case, the terminal 410 may identify the difference between newly scheduled resource Rsc A' and resource Rsc A scheduled at the time when the new reference indicator is configured. In addition, the terminal 410 may identify the difference between the output power Tx Power B value used when the new reference indicator is configured and an output power Tx power B' value to be used at present. In addition, whether the corresponding changes amounts are sufficiently large to determine that the nonlinearity has been changed may be determined through information provided in advance (e.g., the RB offset, the Tx power offset, etc.). For example, when the difference between resource A used for the reference point transmission and resource A' used for this transmission is greater than the RB offset, the terminal 410 may determine that the nonlinearity has been changed. For example, when the difference between transmission power B used for the reference point transmission and transmission power B' used for this transmission is greater than the Tx power offset, the terminal 410 may determine that the nonlinearity has been changed. For example, when the difference between resource A used for the reference point transmission and resource A' used for this transmission is greater than the RB offset and the difference between transmission power B used for the reference point transmission and transmission power B' used for this transmission is greater than the Tx power offset, the terminal 410 may determine that the nonlinearity has been changed.

When the terminal 410 determines that the nonlinearity has not been changed, the terminal 410 may transmit information indicating that the pre-trained inference indicator is true to the base station 400 when new UL data is transmitted, and when the terminal determines that the nonlinearity has been changed, the terminal 410 may transmit information indicating that the pre-trained inference indicator is false to the base station 400. In order to represent the pre-trained inference indicator, information can be explicitly represented by allocating a 1-bit resource, but an implicit method can be also used. For example, when the terminal 410 transmits data, a pilot for channel estimation is transmitted together, and in this case, two pilots that can be transmitted by the terminal 410 are operated so as to specify that the pre-trained inference indicator is true when pilot A is used and the pre-trained inference indicator is false when pilot B is used. Accordingly, the pre-trained inference indicator can be presented without using an additional resource.

In operation S513, the base station 400 may perform distortion correction (i.e., inference) for resource A' by using a pre-trained parameter. For example, the base station 400 may determine that the nonlinearity has not been changed when the difference between resource A used for the reference point transmission and resource A' used for this transmission is not greater than the RB offset and/or when transmission power B used for the reference point transmission and transmission power B' used for this transmission is not greater than the Tx power offset, and may perform, based on the determination, distortion correction (i.e., inference) for resource A' by using the pre-trained parameter. Alternatively, for example, the base station 400 may receive, from the terminal 410, information indicating that the pre-trained inference indicator is true, and may perform, based on the information, distortion correction (i.e., inference) for resource A' by using the pre-trained parameter.

In operation S515, the base station 400 may evaluate the performance of pre-trained inference. When an AI-based nonlinearity compensation (AI-NC) process is performed, the performance of the pre-trained inference can be determined with reference to how much a specific performance metric is enhanced from the application of the AI-NC. For example, when an error vector magnitude (EVM) value is utilized, the base station 400 may compare an EVM value after the AI-NC and an EVM value before the AI-NC, and may determine that the pre-trained inference scheme is not well operated since a gain of the pre-trained inference is small when the corresponding difference is smaller than a threshold. The base station 400 may compare the EVM value after the AI-NC and the EVM value before the AI-NC, and may determine that the pre-trained inference scheme is well operated since a gain of the pre-trained inference is small when the corresponding difference is not smaller than the threshold. For example, the base station 400 may determine, based on whether the pre-trained inference scheme is well operated, the subsequent operation.

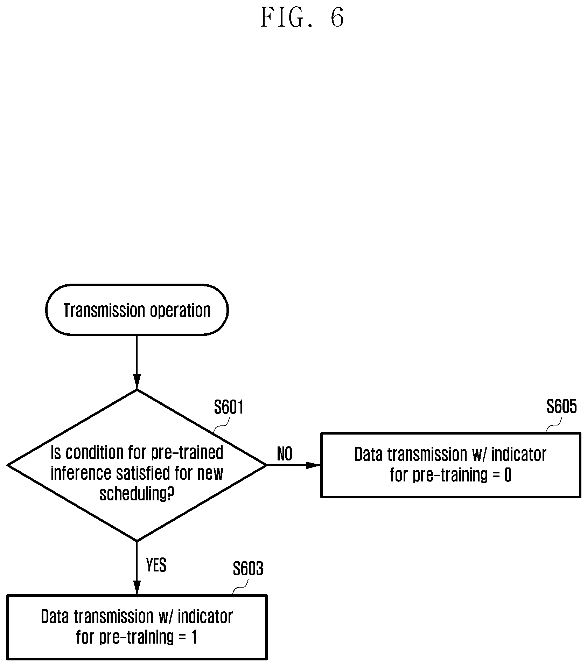

FIG. 6 illustrates an embodiment of a pre-trained inference method of a transmitting end in transmission according to the disclosure.

Referring to FIG. 6, while having all information enabling whether pre-trained inference is possible (i.e., whether nonlinearity has not been changed) to be determined, a transmitting end determines whether pre-trained inference is possible and performs an operation of informing the same through an indicator during data transmission.

In operation S601, the transmitting end may determine whether a pre-trained inference situation has been satisfied for new scheduling. That is, the transmitting end may determine, based on information provided in advance (e.g., an RB offset, a Tx power offset, etc.), whether or not nonlinearity has been changed.

In operation S603, when the nonlinearity has not been changed, the transmitting end may determine that the pre-trained inference situation is satisfied, and may together transmit data including an indicator (e.g., an indicator for pre-trained=1) indicating that the pre-trained inference situation is satisfied.

In operation S605, when the nonlinearity has been changed, the transmitting end may determine that the pre-trained inference situation is satisfied, and may together transmit data including an indicator (e.g., an indicator for pre-trained=0) indicating that the pre-trained inference situation is not satisfied.

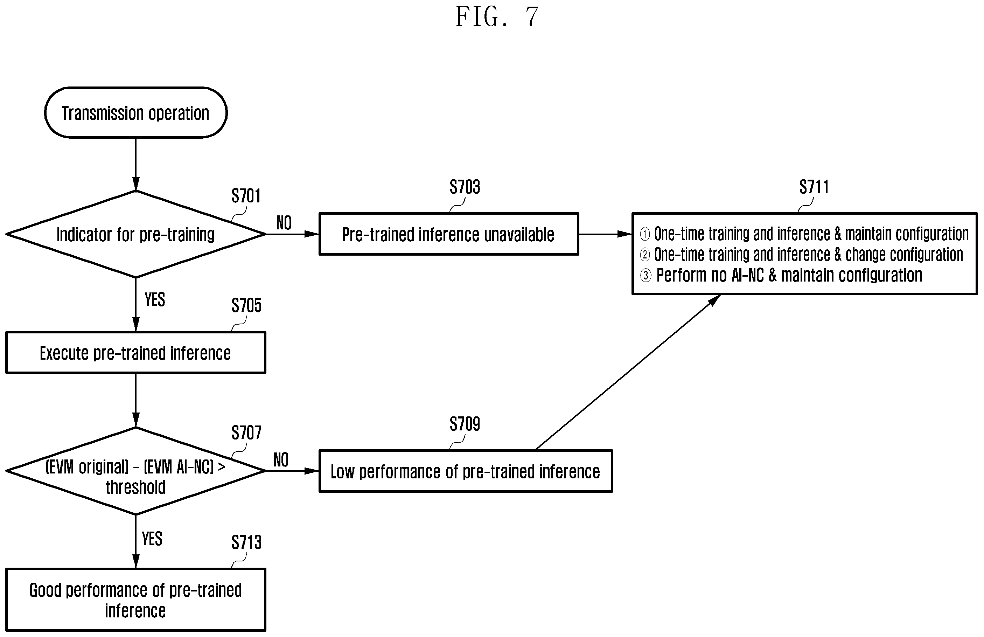

FIG. 7 illustrates an embodiment of a pre-trained inference method of a receiving end in transmission according to the disclosure.

Referring to FIG. 7, whether a pre-trained inference operation can be performed at the receiving end is determined through signaling of a transmitting end.

In operation S701, the receiving end may identify an indicator on whether a pre-trained inference situation is satisfied.

In operation S703, when receiving the indication indicating that the pre-trained inference cannot be performed, the receiving end may consider one of the operations in S711. For example, the receiving end may perform one of the following operations.
1. The receiving end performs an inference process by performing new AI training for current data, but does not change the configuration of a reference point. That is, the receiving end may perform this AI training as a one-off, and remove a related parameter.
2. The receiving end may perform the inference process by performing new AI training, and then may update the previously configured reference point (the position and size of the resource, transmission power of the terminal, etc.) with information on data transmission occurring at the current time. That is, this data transmission (i.e., reception from the perspective of the receiving end) may be a new reference point.
3. The receiving end may attempt data reception without performing the AI-based NC process. In this case, the reference point may remain the same.

In addition, even though the pre-trained inference is executed, if the performance of the pre-trained inference is not good, as mentioned in FIG. 3, one of the above-mentioned operations of the receiving end may be considered.

In operation S705, when receiving the indication indicating that the pre-trained inference can be performed, the receiving end may perform the pre-trained inference. In operation S707, the receiving end may determine the performance of distortion correction through the AI-NC.

In operation S709, the receiving end may compare the EVM value when the AI-NC distortion correction is performed and the EVM value before the AI-NC distortion correction is performed, and may determine that the pre-trained inference scheme is not well operated since a gain of the pre-trained inference is small when the corresponding difference is smaller than a threshold. In this case, the receiving end may perform operation S711.

In operation S713, the receiving end may compare the EVM value when the AI-NC distortion correction is performed and the EVM value before the AI-NC distortion correction is performed, and may determine that the pre-trained inference scheme is well operated since a gain of the pre-trained inference is large when the corresponding difference is not smaller than the threshold.

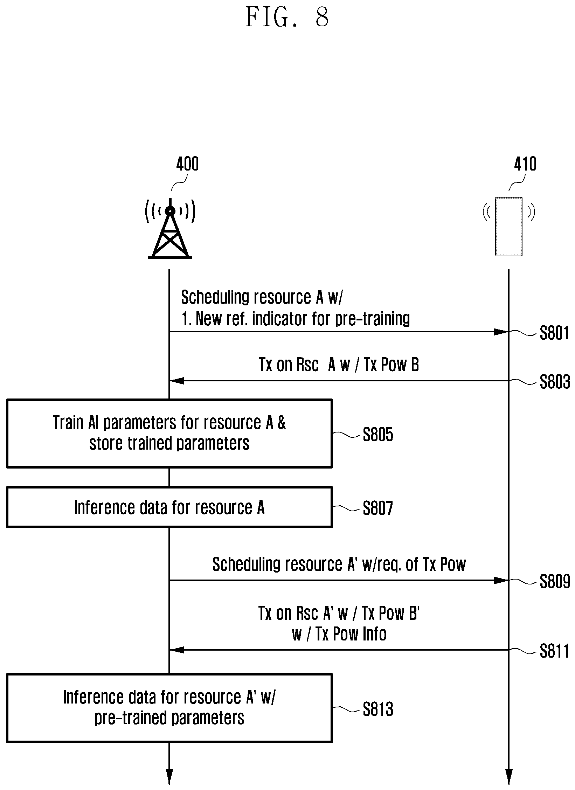

As a modified example of FIG. 5, as in FIG. 8, a method of performing operation without sharing information required to determine the change of the nonlinearity, such as the RB offset or the Tx power offset, to the terminal by the base station.

FIG. 8 illustrates an embodiment of a method of performing pre-trained inference in a UL case according to the disclosure.

Referring to FIG. 8, information on the position and size of a frequency, and the like is information that the base station 400 already knows, and the base station 400 may determine the change of the nonlinearity without providing the information separately to the terminal 410. Additionally, when the terminal 410 provides information on Tx power to the base station 400, the base station 400 may determine the change of the nonlinearity. In this case, also for the Tx power information, the terminal 410 may reduce the number of bits used for exchanging Tx power information by utilizing a table pre-shared with the base station 400 and exchanging only an index. Alternatively, the terminal 410 may transmit a change mount of a Tx power value compared to the previous Tx power to the base station 400.

Referring to FIG. 8, in operation S801, the base station 400 may schedule resource A for UL transmission to the terminal 410. When performing scheduling for specific UL data transmission to the terminal 410, the base station 400 may schedule a resource, which is Resource A (or Rsc A), and may also transmit new reference indicator information indicating that a currently transmitted situation is configured as a new reference point. In addition, the terminal 410 may inform the base station 400 of information enabling whether the nonlinearity has been changed to be determined. That is, the inference is performed at the receiving end, and thus the receiving end may inform the transmitting end of information enabling whether the nonlinearity has been changed to be determined. In operation S803, the terminal 410 may perform UL transmission to the base station 400 through scheduled resource A at transmission power B.

For example, when the position of a currently scheduled resource is greatly changed by more than an RB offset, the base station 400 may determine, using provided information RB offset, that nonlinearity has been changed. Alternatively, the base station 400 may determine, using provided information Tx power offset, that nonlinearity has been changed when a difference between current output power Tx power B of the terminal 410 and output power Tx power B' to be used by the terminal 410 later is greater than the Tx power offset. Other factors which can affect nonlinearity, such as the size of the frequency resource, as well as the described embodiment may be used to define a criterion to determine whether the nonlinearity has been changed through sharing information in advance between the base station 400 and the terminal 410. In addition, various factors may be considered comprehensively to determine that the nonlinearity has been determined. For example, a change amount (X) of Tx power and a change amount (Y) of the frequency resource position may be considered comprehensively to determine that the nonlinearity has been changed when a value of (X+Y) is equal to or greater than Z. As advance information used to determine whether the nonlinearity has been changed, such as an RB offset or a Tx power offset, values agreed in advance between the terminal 410 and the base station 400 may be stored as a table and used. In this case, only an index value is exchanged for sharing the advance information, and thus a signaling cost can be reduced. In addition, the information required to determine the change of the nonlinearity, such as the RB offset or the Tx power, has a default value, and a default value commonly known to the terminal 410 and the base station 400 may be used even when no advance information is shared. The advance information used to determine the change of the nonlinearity, such as the RB offset or the Tx power offset, may be exchanged in advance in any prior operations in which the terminal 410 and the base station 400 communicate, rather than at a time point of setting a new reference point. For example, at a time point at which the terminal 410 accesses the base station 400, the base station 400 may share, in advance, the advance information used to determine the change of the nonlinearity to the terminal 410. The examples of a method for determining, by the base station 400, an accurate value of advance information used to determine the change of the nonlinearity, such as the RB offset or the Tx power offset, are as follows.
1) Values pre-stored in the base station 400 through a preliminary experiment, etc.
2) Make determination based on nonlinearity-related information provided by the terminal 410 when the information is terminal-specific information
3) Make adjustment adaptively to the performance of pre-trained inference

In operation S805, the base station 400 may train AI-NC parameters for resource A. The base station 400 may train AI-NC parameters by using a pilot signal included in the transmitted signal. The new reference indicator is specified by the base station 400 in operation S801, and thus the terminal 410 may store the Tx power B value and the resource A value used thereafter. The base station 400 needs to store the AI-NC parameters after training the AI network since the AI-NC parameters can be reused later. Here, the AI-NC parameters may refer to parameters for distortion correction of the nonlinearity of the PA.

In operation S807, the base station 400 may perform distortion correction (or inference) of data for resource A.

In operation S809, the base station 400 may transmit information on scheduling for the second data transmission (i.e., transmission after configuration of the reference point) to the terminal 410. In operation S811, the terminal 410 may perform UL transmission to the base station 400 through resource A' at transmission power B'. In this case, the terminal 410 may transmit transmission power information for this UL transmission to the base station 400.

In addition, the base station 400 may utilize not only the Tx power information transmitted by the terminal 410 during data transmission but also information enabling Tx power provided to the base station 400 by the terminal 410 to be estimated for other purposes. For example, the terminal 410 may provide the base station 400 with information such as how much currently used power of the terminal 410 can be increased to maximum transmit power by using a procedure such as a power headroom report, and utilizing such information can be also considered.

The base station 400 may identify the difference between Rsc A' and resource Rsc A scheduled at the time when the new reference indicator is configured. In addition, the base station 400 may identify the difference between the output power Tx Power B value used when the new reference indicator is configured and an output power Tx power B' value to be used at present. In addition, whether the corresponding changes amounts are sufficiently large to determine that the nonlinearity has been changed may be determined through information provided in advance (e.g., the RB offset, the Tx power offset, etc.). For example, when the difference between resource A used for the reference point transmission and resource A' used for this transmission is greater than the RB offset, the base station 400 may determine that the nonlinearity has been changed. For example, when the difference between transmission power B used for the reference point transmission and transmission power B' used for this transmission is greater than the Tx power offset, the base station 400 may determine that the nonlinearity has been changed. For example, when the difference between resource A used for the reference point transmission and resource A' used for this transmission is greater than the RB offset and the difference between transmission power B used for the reference point transmission and transmission power B' used for this transmission is greater than the Tx power offset, the base station 400 may determine that the nonlinearity has been changed.

In operation S813, the base station 400 may perform distortion correction (i.e., inference) for resource A' by using a pre-trained parameter. For example, the base station 400 may determine that the nonlinearity has not been changed when the difference between resource A used for the reference point transmission and resource A' used for this transmission is not greater than the RB offset and/or when transmission power B used for the reference point transmission and transmission power B' used for this transmission is not greater than the Tx power offset, and may perform, based on the determination, distortion correction (i.e., inference) for resource A' by using the pre-trained parameter.

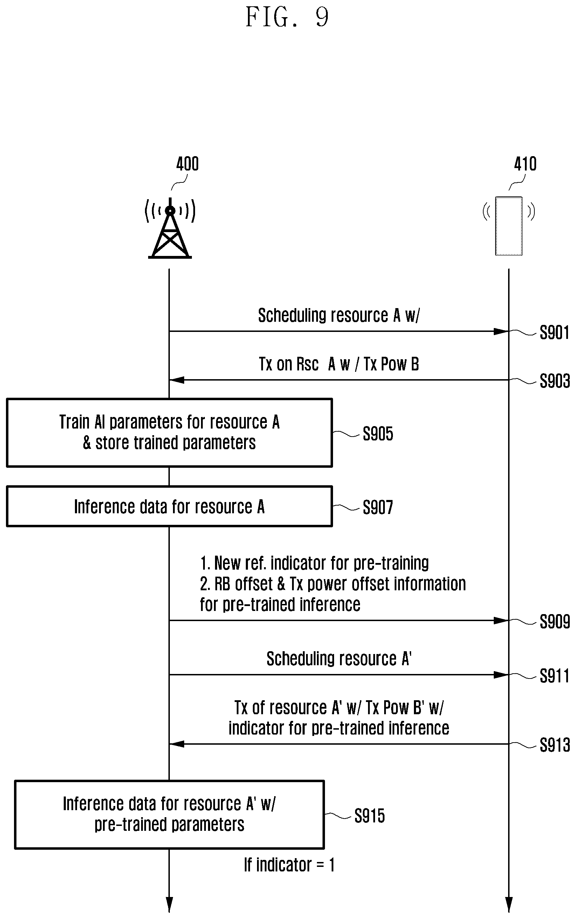

As a modified example of FIG. 5, as in FIG. 9, the base station may perform AI training and inference and then determine whether to specify a new reference point after identifying a result of the AI training and inference.

FIG. 9 illustrates an embodiment of a method of performing pre-trained inference in a UL case according to the disclosure.

Referring to FIG. 9, a base station 400 may perform distortion correction through AI-NC and then identify a result thereof in operation S907, and may determine whether to designate a new reference point in operation S909.

Operations S901 to S915 except for operation S909 may be performed in the same or similar manner as operations S801 to S813.

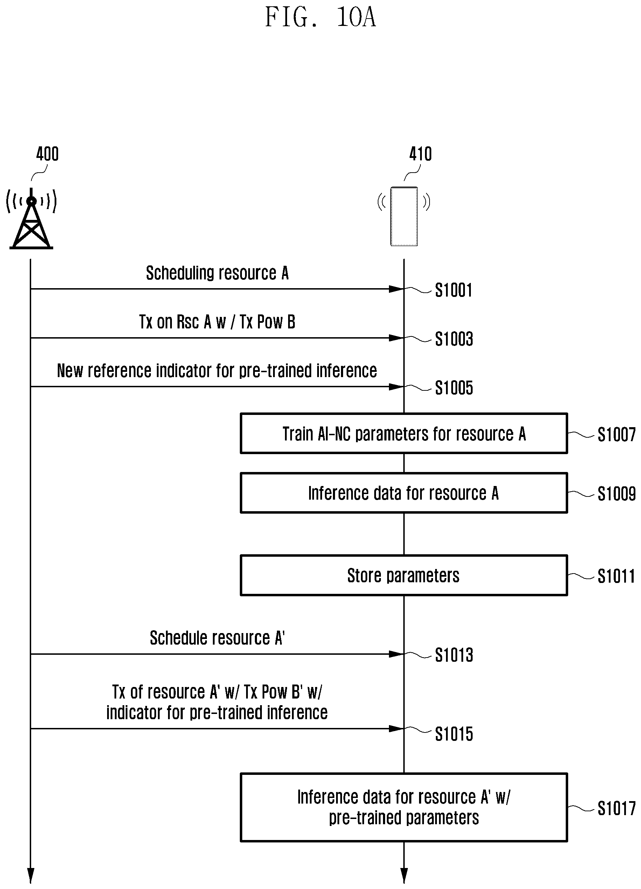

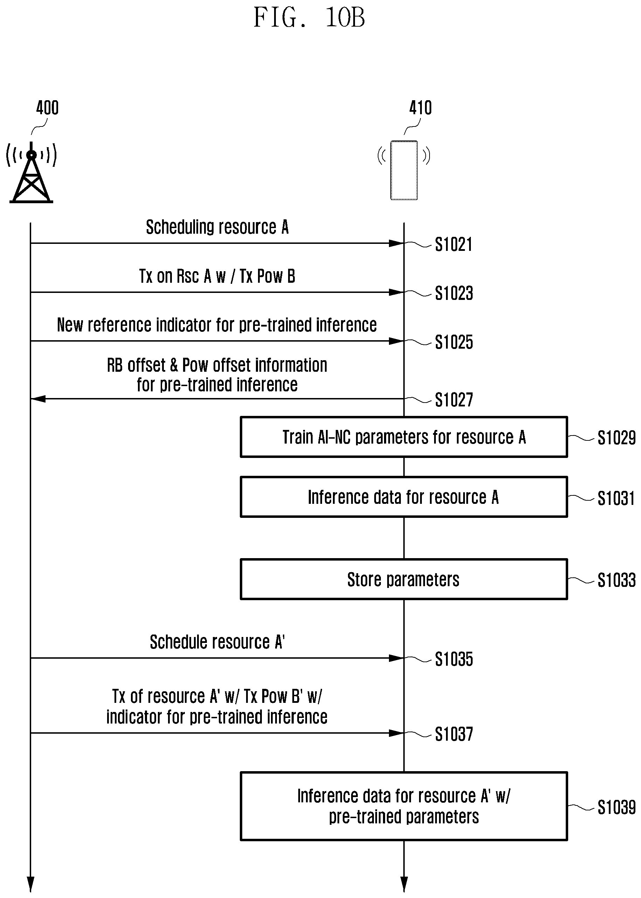

FIGS. 10A and 10B illustrate an embodiment of a method for performing pre-trained inference in a UL case according to the disclosure.

FIGS. 10A and 10B specifically describe, with reference to a DL case, procedures required to omit a training process by a base station and a terminal. In the DL case, the base station needs to determine whether the terminal is a terminal having a capability of performing an AI-based NC process, and for this, a method for reporting and determining whether the terminal has a capability of performing the AI-based NC in an operation in which the terminal reports a capability of the terminal in a process of initially accessing the base station, or the like can be considered.

In operation S1001, when performing scheduling of specific DL data transmission for the terminal 410, the base station 400 schedules a resource, which is Resource A (or Rsc A).

In operation S1003, the base station 400 may perform DL transmission to the terminal 410 through resource A at transmission power B.

In operation S1005, the base station 400 may transmit new reference indicator information indicating that a current transmission situation is to be set to a new reference point. Unlike the UL case, in general, the base station 400 may not transmit, to the terminal 410, information which is helpful to determine a change of nonlinearity, such as an RB offset or a Tx power offset, and this is because the base station 400 may all know not only the position and size of the frequency resource but also output power, etc. during DL transmission, and thus the base station may inform the terminal 410 of whether to perform pre-trained inference by indicating true/false information through a pre-trained indicator and transmitting the same during scheduling later, without providing the information which is helpful to determine change of nonlinearity to the terminal 410.

In operation S1007, the terminal 410 may train AI-NC parameters for resource A. The terminal 410 may train AI-NC parameters by using a pilot signal included in the transmitted signal.

In operation S1009, the terminal 410 may perform distortion correction (or inference) of data for resource A.

In operation S1011, for the new reference point, the terminal 410 needs to store the AI-NC parameters after training the AI network since the AI-NC parameters can be reused later. Here, the AI-NC parameters may refer to parameters for distortion correction of the nonlinearity of the PA.

In operation S1013, the base station 400 may transmit information on scheduling for the second data transmission (i.e., transmission after configuration of the reference point) to the terminal 410. In operation S1015, the base station 400 may perform DL transmission to the terminal 410 through resource A' at transmission power B'. In this case, the terminal 410 may identify the difference between newly scheduled resource Rsc A' and resource Rsc A scheduled at the time when the new reference indicator is configured. In addition, the terminal 410 may identify the difference between the output power Tx Power B value used when the new reference indicator is configured and an output power Tx power B' value to be used at present. In addition, whether the corresponding changes amounts are sufficiently large to determine that the nonlinearity has been changed may be determined through information provided in advance (e.g., the RB offset, the Tx power offset, etc.). For example, when the difference between resource A used for the reference point transmission and resource A' used for this transmission is greater than the RB offset, the terminal 410 may determine that the nonlinearity has been changed. For example, when the difference between transmission power B used for the reference point transmission and transmission power B' used for this transmission is greater than the Tx power offset, the terminal 410 may determine that the nonlinearity has been changed. For example, when the difference between resource A used for the reference point transmission and resource A' used for this transmission is greater than the RB offset and the difference between transmission power B used for the reference point transmission and transmission power B' used for this transmission is greater than the Tx power offset, the terminal 410 may determine that the nonlinearity has been changed.

In operation S1017, the terminal 410 may perform distortion correction (i.e., inference) for resource A' by using a pre-trained parameter. For example, the terminal 410 may determine that the nonlinearity has not been changed when the difference between resource A used for the reference point transmission and resource A' used for this transmission is not greater than the RB offset and/or when transmission power B used for the reference point transmission and transmission power B' used for this transmission is not greater than the Tx power offset, and may perform, based on the determination, distortion correction (i.e., inference) for resource A' by using the pre-trained parameter.

However, as in operation S1027 of FIG. 10B, when terminal-specific information is required from the terminal 410, and the like, in order to identify a change of nonlinearity, such as an RB offset or Ts power offset, the terminal-specific information may be provided from the terminal 410 when the new reference point is specified.

Here, operations S1021 to S1039 except for operation S1027 may be performed in the same or similar manner as operations S1001 to S1017.

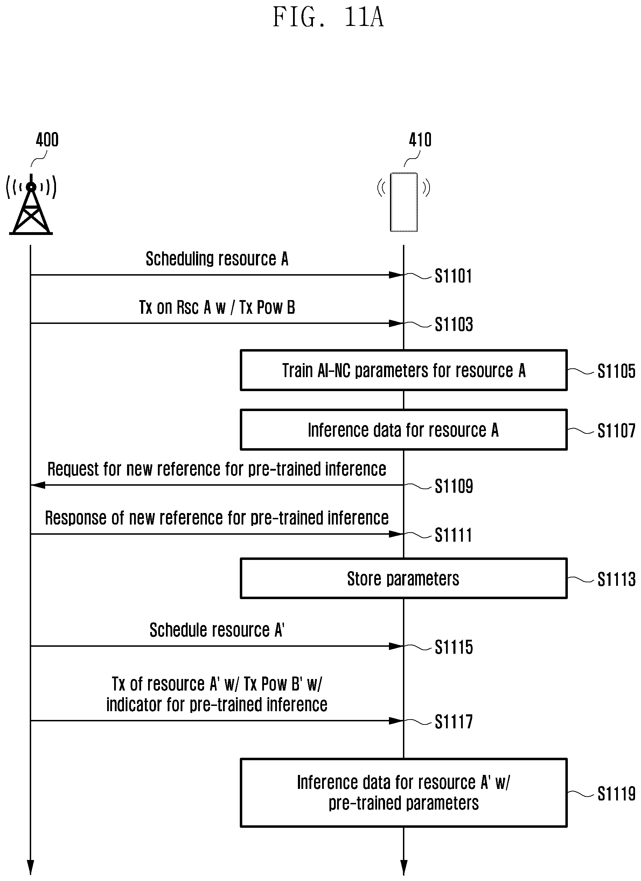

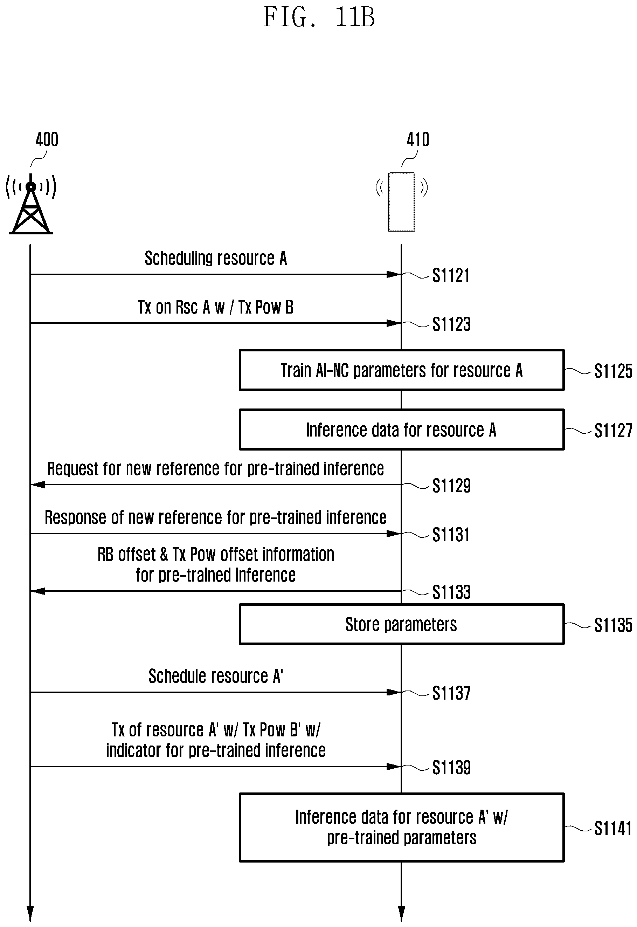

As a modified example of FIG. 10, in FIG. 11, after receiving scheduling and receiving DL data transmitted from the base station, the terminal may request, from the base station, to specify a new reference point based on a current transmission situation, based on a result of an AI-based NC process after performing the same, and may receive a result of the corresponding request from the base station through a response message.

FIGS. 11A and 11B illustrate an embodiment of a method for performing pre-trained inference in a UL case according to the disclosure.

FIGS. 11A and 11B specifically illustrate, with reference to a DL case, procedures required to omit a training process by the base station 400 and the terminal 410. The base station 400 needs to determine whether the terminal 410 is a terminal 410 having a capability of performing an AI-based NC process, and for this, a method for reporting and determining whether the terminal 410 has a capability of performing the AI-based NC in an operation in which the terminal 410 reports a capability of the terminal 410 in a process of initially accessing the base station 400, or the like can be considered.

In operation S1101, when performing scheduling of specific DL data transmission for the terminal 410, the base station 400 schedules a resource, which is Resource A (or Rsc A).

In operation 1103, the base station 400 may perform DL transmission to the terminal 410 through resource A at transmission power B.

In operation S1105, the terminal 410 may train AI-NC parameters for resource A. The terminal 410 may train AI-NC parameters by using a pilot signal included in the transmitted signal.

In operation S1107, the terminal 410 may perform distortion correction (or inference) of data for resource A.

In operation S1109, after receiving scheduling and receiving DL data transmitted from the base station 400, the terminal 410 may request, from the base station 400, to specify a new reference point based on a current transmission situation, based on a result of an AI-based NC process after performing the same.

In operation S1111, the base station 400 may transmit a new reference response message including the result of the new reference request to the terminal 410.

In operation S1113, for the new reference point, the terminal 410 needs to store the AI-NC parameters after training the AI network since the AI-NC parameters can be reused later. Here, the AI-NC parameters may refer to parameters for distortion correction of the nonlinearity of the PA.

In operation S1115, the base station 400 may transmit information on scheduling for the second data transmission (i.e., transmission after configuration of the reference point) to the terminal 410. In operation S1117, the base station 400 may perform DL transmission to the terminal 410 through resource A' at transmission power B'. In this case, the terminal 410 may identify the difference between newly scheduled resource Rsc A' and resource Rsc A scheduled at the time when the new reference indicator is configured. In addition, the terminal 410 may identify the difference between the output power Tx Power B value used when the new reference indicator is configured and an output power Tx power B' value to be used at present. In addition, whether the corresponding changes amounts are sufficiently large to determine that the nonlinearity has been changed may be determined through information provided in advance (e.g., the RB offset, the Tx power offset, etc.). For example, when the difference between resource A used for the reference point transmission and resource A' used for this transmission is greater than the RB offset, the terminal 410 may determine that the nonlinearity has been changed. For example, when the difference between transmission power B used for the reference point transmission and transmission power B' used for this transmission is greater than the Tx power offset, the terminal 410 may determine that the nonlinearity has been changed. For example, when the difference between resource A used for the reference point transmission and resource A' used for this transmission is greater than the RB offset and the difference between transmission power B used for the reference point transmission and transmission power B' used for this transmission is greater than the Tx power offset, the terminal 410 may determine that the nonlinearity has been changed

In operation S1119, the terminal 410 may perform distortion correction (i.e., inference) for resource A' by using a pre-trained parameter. For example, the terminal 410 may determine that the nonlinearity has not been changed when the difference between resource A used for the reference point transmission and resource A' used for this transmission is not greater than the RB offset and/or when transmission power B used for the reference point transmission and transmission power B' used for this transmission is not greater than the Tx power offset, and may perform, based on the determination, distortion correction (i.e., inference) for resource A' by using the pre- trained parameter.

As in operation S1133 of FIG. 10B, when the base station 400 requires terminal-specific information from the terminal, and the like, in order to identify a change of nonlinearity, such as an RB offset or Ts power offset, the terminal-specific information may be provided from the terminal 410 when the new reference point is specified

Here, operations S1121 to S1141 except for operation S1133 may be performed in the same or similar manner as operations S1101 to S1119.

The operations shown in each of FIGS. 4 to 11 above are not necessary operations and some may be omitted. In addition, the method of each figure is divided and described to help understanding, but is not necessarily to be used independently.

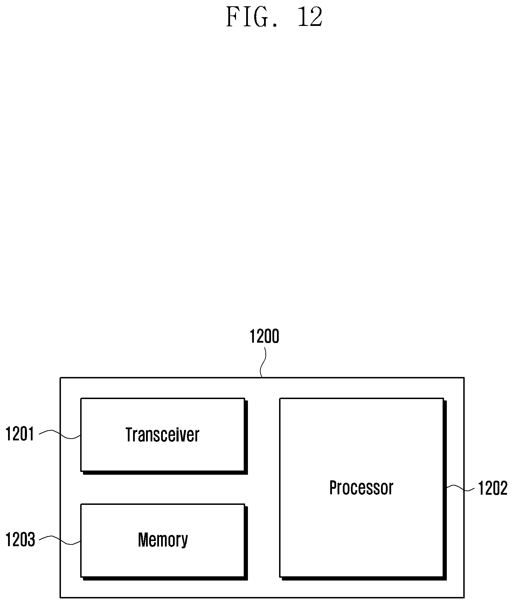

FIG. 12 is a block diagram illustrating a terminal according to an embodiment of the disclosure.

Referring to FIG. 12, a terminal 1200 may include a transceiver 1201, a controller (processor) 1202, and a storage (memory) 1203. The transceiver 1201, the controller 1202, and the storage 1203 of the terminal 1200 may operate according to an embodiment of the disclosure. However, elements of the terminal 1200 according to an embodiment are not limited to the above-described example. According to another embodiment, the terminal 1200 may include more or fewer elements than the above-described elements. In addition, in a specific case, the transceiver 1201, the controller 1202, and the storage 1203 may be implemented in the form of a single chip.

The transceiver 1201 may include a transmitter and a receiver according to another embodiment. The transceiver 1201 may transmit or receive a signal to or from a base station. The signal may include control information and data. To this end, the transceiver 1201 may include an RF transmitter for up-converting and amplifying the frequency of a transmitted signal, and an RF receiver for performing low-noise amplification of a received signal and performing down-conversion of the frequency thereof. In addition, the transceiver 1201 may receive a signal through a wireless channel, output the received signal to the controller 1202, and transmit a signal output from the controller 1202 through a wireless channel.

The controller 1202 may control a series of procedures so as to enable the terminal 1200 to perform operations according to the above-described embodiment of the disclosure. To this end, the controller 1202 may include at least one processor. For example, the controller 1202 may include a communication processor (CP) for performing control for communication and an application processor (AP) for controlling a higher layer such as an application program.

The storage 1203 may store control information or data included in a signal obtained from the terminal 1200, and may include an area for storing data required for control of the controller 1202 and data generated during control by the controller 1202.

In addition, the terminal 1200 may include an AI device (not shown) capable of performing at least a part of AI processing. The AI device may include an AI processor, a memory, and/or a communication unit.

For example, the controller 1202 may operate as an AI processor or perform at least some functions of the AI processor. The AI processor may learn a neural network using a program stored in the memory. Here, the neural network may be designed to simulate the structure of the human brain on a computer, and include multiple weighted network nodes that simulate the neurons of the human neural network. Multiple network nodes may transmit and receive data according to each connection relationship to simulate the synaptic activity of a neuron transmitting and receiving signals through a synapse. Here, neural networks may include deep learning models developed from neural network models. In the deep-learning model, multiple network nodes are located in different layers and may transmit and receive data according to a convolution connection relationship.

Meanwhile, the AI processor may include a data learning unit for learning the neural network for data classification/recognition. The data learning unit may classify data to be used for learning and acquire data to be learned. The data learning unit may learn the deep learning model by applying the acquired learning data to the deep learning model. For example, a deep learning model may be trained through supervised learning or unsupervised learning. In addition, the data learning unit may learn the deep learning model through reinforcement learning using feedback about whether the result of the situation determination according to learning is correct. The deep learning model may be trained based on the data of the input layer and the output layer.

The data learning unit may be manufactured in the form of at least one hardware chip and may be mounted on an AI device. For example, the data learning unit may be manufactured in the form of a dedicated hardware chip for artificial intelligence (AI), or manufactured as a part of a general processor (CPU) or a graphics-only processor (GPU) and be mounted on an AI device. In addition, the data learning unit may be implemented by a software module. If the data learning unit is implemented by a software module (or a program module including instructions), the software module may be stored in non-transitory computer-readable recording media. In this case, at least one software module may be provided by an operating system (OS) or an application.

For example, the storage 1203 may include a memory of the AI device. The memory may store various programs and data necessary for the operation of the AI device. The memory is accessed by the AI processor, and data may be read/written/modified/deleted/updated by the AI processor. For example, the data learning unit may store a trained model associated with input/output relationship information of a PA in the memory.

For example, the communication unit of the AI device may be included in the transceiver 1201.

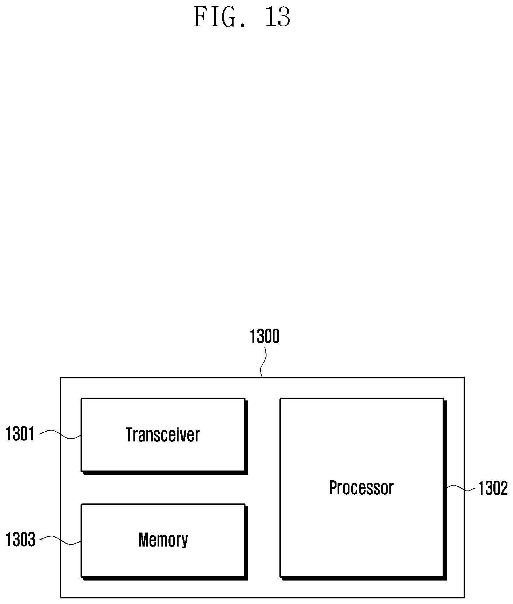

FIG. 13 is a block diagram illustrating a base station according to an embodiment of the disclosure.

Referring to FIG. 13, a base station 1300 may include a transceiver 1301, a controller (e.g., a processor) 1302, and a storage (e.g., memory) 1303. According to an embodiment of the disclosure, the transceiver 1301, the controller 1302, and the storage 1303 of the base station 1300 may operate. However, elements of the base station 1300 according to an embodiment are not limited to the above-described example. According to another embodiment, the base station 1300 may include more or fewer elements than the above-described elements. In addition, in a specific case, the transceiver 1301, the controller 1302, and the storage 1303 may be implemented in the form of a single chip.

The transceiver 1301 may include a transmitter and a receiver according to another embodiment. The transceiver 1301 may transmit or receive a signal to or from a terminal. The signal may include control information and data. To this end, the transceiver 1301 may include an RF transmitter for up-converting and amplifying the frequency of a transmitted signal, and an RF receiver for performing low-noise amplification of a received signal and performing down-conversion of the frequency thereof. In addition, the transceiver 1301 may receive a signal through a wireless channel, output the received signal to the controller 1302, and transmit a signal output from the controller 1302 through a wireless channel.

The controller 1302 may control a series of procedures so as to enable the base station 1300 to perform operations according to the above-described embodiment of the disclosure. To this end, the controller 1302 may include at least one processor. For example, the controller 1302 may include a CP for performing control for communication and an AP for controlling a higher layer such as an application program.

The storage 1303 may store control information and data determined by the base station 1300 or control information and data received from the terminal, and may include an area for storing data required for control of the controller 1302 and data generated during control by the controller 1302.

In addition, the base station 1300 may include an AI device (not shown) capable of performing at least a part of AI processing. The AI device may include an AI processor, a memory, and/or a communication unit.

For example, the controller 1302 may operate as an AI processor or perform at least some functions of the AI processor. The AI processor may learn a neural network using a program stored in the memory. Here, the neural network may be designed to simulate the structure of the human brain on a computer, and include multiple weighted network nodes that simulate the neurons of the human neural network. Multiple network nodes may transmit and receive data according to each connection relationship to simulate the synaptic activity of a neuron transmitting and receiving signals through a synapse. Here, neural networks may include deep learning models developed from neural network models. In the deep-learning model, multiple network nodes are located in different layers and may transmit and receive data according to the convolution connection relationship.

Meanwhile, the AI processor may include a data learning unit for learning the neural network for data classification/recognition. The data learning unit may classify data to be used for learning and acquire data to be learned. The data learning unit may learn the deep learning model by applying the acquired learning data to the deep learning model. For example, a deep learning model may be trained through supervised learning or unsupervised learning. In addition, the data learning unit may learn the deep learning model through reinforcement learning using feedback about whether the result of the situation determination according to learning is correct. For example, the data learning unit may classify the received pilot part as data of an input layer and classify a previously known pilot as data of an output layer by reflecting an amplitude scaling factor to the same. The deep learning model may be trained based on the data of the input layer and the output layer. In addition, based on the trained model, inference can be made using the data part of the received signal as an input layer.

The data learning unit may be manufactured in the form of at least one hardware chip and may be mounted on an AI device. For example, the data learning unit may be manufactured in the form of a dedicated hardware chip for artificial intelligence (AI), or manufactured as a part of a general processor (CPU) or a graphics-only processor (GPU) and be mounted on an AI device. In addition, the data learning unit may be implemented by a software module. If the data learning unit is implemented by a software module (or a program module including instructions), the software module may be stored in non-transitory computer-readable recording media. In this case, at least one software module may be provided by an OS or an application.

For example, the storage 1303 may include a memory of the AI device. The memory may store various programs and data necessary for the operation of the AI device. The memory is accessed by the AI processor, and data may be read/written/modified/deleted/updated by the AI processor. For example, the data learning unit may store a trained model associated with input/output relationship information of a PA in the memory.

For example, the communication unit of the AI device may be included in the transceiver 1301.

In methods of the disclosure, some or all of the contents of each embodiment may be implemented in combination without departing from the essential spirit and scope of the disclosure.

The embodiments of the disclosure described and shown in the specification and the drawings are merely specific examples that have been presented to easily explain the technical contents of the disclosure and help understanding of the disclosure, and are not intended to limit the scope of the disclosure. That is, it will be apparent to those skilled in the art that other variants based on the technical idea of the disclosure may be implemented.

Furthermore, although exemplary embodiments of the disclosure have been described and shown in the specification and the drawings by using particular terms, they have been used in a general sense merely to easily explain the technical contents of the disclosure and help understanding of the disclosure, and are not intended to limit the scope of the disclosure. It will be apparent to those skilled in the art that, in addition to the embodiments set forth herein, other variants based on the technical idea of the disclosure may be implemented.

## Claims

1. A method performed by a receiver in a wireless communication system, the method comprising:
receiving, from a transmitter, first uplink data via a first resource;
acquiring a first parameter for compensation of the nonlinearity of a power amplifier (PA) for the first resource through artificial intelligence (AI) training;
performing distortion correction of the nonlinearity of the first uplink data based on the first parameter;
receiving, from the transmitter, second uplink data via a second resource; and
identifying whether the nonlinearity of the PA is changed between transmission of the first uplink data and transmission of the second uplink data.

2. The method of claim 1, further comprising transmitting, to the transmitter, information indicating that the transmission of the first uplink data is a reference point,
wherein whether the nonlinearity of the PA is changed is determined based on at least one of a frequency offset between the first resource and the second resource and a difference value between transmission power of the first uplink data and transmission power of the second uplink data.

3. The method of claim 2, wherein, based on that the nonlinearity of the PA is not changed between the transmission of the first uplink data and the transmission of the second uplink data, acquiring a second parameter for compensation of the nonlinearity of the PA for the second resource through AI training is omitted, and
wherein distortion correction of the nonlinearity of the second uplink data is performed based on the first parameter.

4. The method of claim 2, further comprising:
based on that the nonlinearity of the PA is changed between the transmission of the first uplink data and the transmission of the second uplink data, acquiring a second parameter for compensation of the nonlinearity of the PA for the second resource through AI training; and
performing distortion correction of the nonlinearity of the second uplink data based on the second parameter,
wherein the transmission of the first uplink data is maintained as the reference point.

5. The method of claim 2, further comprising:
based on that the nonlinearity of the PA is changed between the transmission of the first uplink data and the transmission of the second uplink data, acquiring a second parameter for compensation of the nonlinearity of the PA for the second resource through AI training;
performing distortion correction of the nonlinearity of the second uplink data based on the second parameter; and
transmitting information indicating that the transmission of the second uplink data is the reference point,
wherein, based on that the nonlinearity of the PA is changed between the transmission of the first uplink data and the transmission of the second uplink data, the performing of the distortion correction of the nonlinearity of the second uplink data is omitted.

6. The method of claim 3, comprising, based on a result of the distortion correction of the nonlinearity of the second uplink data, determining at least one of whether to perform distortion correction of the nonlinearity of third uplink data, based on the first parameter, whether to configure the transmission of the second uplink data as a reference point, or whether to suspend the distortion correction of the nonlinearity.

7. The method of claim 6, further comprising, in case that the transmission of the second uplink data is configured as the reference point,
acquiring a second parameter for compensation of the nonlinearity of the PA for the second resource through AI training;
performing distortion correction of the nonlinearity of the second uplink data based on the second parameter;
receiving, from the transmitter, third uplink data via a third resource; and
identifying whether the nonlinearity of the PA is changed between transmission of the second uplink data and transmission of the third uplink data.

8. The method of claim 3, further comprising:
identifying a difference between a pre-configured threshold value and a difference value between an EVM value of the first uplink data for which the distortion correction of the nonlinearity is performed and an EVM value of third uplink data for which the distortion correction of the nonlinearity is not performed; and
determining whether to change the reference point based on the difference.

9. A receiver in a wireless communication system, the receiver comprising:
a transceiver; and
a controller,
wherein the controller is configured to:
receive, from a transmitter, first uplink data via a first resource;
acquire a first parameter for compensation of the nonlinearity of a power amplifier (PA) for the first resource through artificial intelligence (AI) training;
perform distortion correction of the nonlinearity of the first uplink data based on the first parameter;
receive, from the transmitter, second uplink data via a second resource; and
identify whether the nonlinearity of the PA is changed between transmission of the first uplink data and transmission of the second uplink data.

10. The receiver of claim 9, wherein whether the nonlinearity of the PA is changed is determined based on at least one of a frequency offset between the first resource and the second resource and a difference value between transmission power of the first uplink data and transmission power of the second uplink data, and
wherein information indicating that the transmission of the first uplink data is a reference point is transmitted to the transmitter.

11. The receiver of claim 10, wherein, based on that the nonlinearity of the PA is not changed between the transmission of the first uplink data and the transmission of the second uplink data, acquiring a second parameter for compensation of the nonlinearity of the PA for the second resource through AI training is omitted, and
wherein distortion correction of the nonlinearity of the second uplink data is performed based on the first parameter.

12. The receiver of claim 10, wherein the controller is further configured to:
based on that the nonlinearity of the PA is changed between the transmission of the first uplink data and the transmission of the second uplink data, acquire a second parameter for compensation of the nonlinearity of the PA for the second resource through AI training; and
perform distortion correction of the nonlinearity of the second uplink data based on the second parameter, and
wherein the transmission of the first uplink data is maintained as the reference point.

13. The receiver of claim 10, wherein the controller is further configured to:
based on that the nonlinearity of the PA is changed between the transmission of the first uplink data and the transmission of the second uplink data, acquire a second parameter for compensation of the nonlinearity of the PA for the second resource through AI training;
perform distortion correction of the nonlinearity of the second uplink data based on the second parameter; and
transmit information indicating that the transmission of the second uplink data is the reference point, and
wherein, based on that the nonlinearity of the PA is changed between the transmission of the first uplink data and the transmission of the second uplink data, the performing of the distortion correction of the nonlinearity of the second uplink data is omitted.

14. The receiver of claim 11, wherein the controller is configured to, based on a result of the distortion correction of the nonlinearity of the second uplink data, determine at least one of whether to perform distortion correction of the nonlinearity of third uplink data, based on the first parameter, whether to configure the transmission of the second uplink data as a reference point, or whether to suspend the distortion correction of the nonlinearity.

15. The receiver of claim 14, wherein the controller is further configured to, in case that the transmission of the second uplink data is configured as the reference point,
acquire a second parameter for compensation of the nonlinearity of the PA for the second resource through AI training;
perform distortion correction of the nonlinearity of the second uplink data based on the second parameter;
receive, from the transmitter, third uplink data via a third resource; and
identify whether the nonlinearity of the PA is changed between transmission of the second uplink data and transmission of the third uplink data.
